(19) Europäisches Patentamt
European Patent Office
Office européen des brevets

(11) **EP 1 279 966 B1**

(12) **EUROPÄISCHE PATENTSCHRIFT**

(45) Veröffentlichungstag und Bekanntmachung des Hinweises auf die Patenterteilung:
**20.04.2005 Patentblatt 2005/16**

(51) Int Cl.⁷: **G01R 31/3173**, G01R 31/316

(21) Anmeldenummer: **02014934.0**

(22) Anmeldetag: **08.07.2002**

(54) **Vorrichtung und Verfahren zur Erfassung der Zuverlässigkeit von integrierten Halbleiterbauelementen bei hohen Temperaturen**

Apparatus and method for determining the reliability of integrated semiconductor circuits at high temperatures

Dispositif et procédé pour déterminer la fiabilité à hautes températures de circuits semi-conducteurs intégrés

(84) Benannte Vertragsstaaten:
**FR IT**

(30) Priorität: **23.07.2001 DE 10135805**

(43) Veröffentlichungstag der Anmeldung:
**29.01.2003 Patentblatt 2003/05**

(73) Patentinhaber: **Infineon Technologies AG
81669 München (DE)**

(72) Erfinder:
• **Asam, Wilhelm
80804 München (DE)**
• **Fazekas, Josef
81476 München (DE)**
• **Martin, Andreas
81539 München (DE)**
• **Smeets, David
81541 München (DE)**
• **von Hagen, Jochen
83059 Kolbermoor (DE)**

(74) Vertreter: **Kindermann, Peter, Dipl.-Ing.
Kindermann Patentanwälte
Karl-Böhm-Strasse 1
85598 Baldham (DE)**

(56) Entgegenhaltungen:
US-A- 4 356 379    US-A- 5 309 090
US-A- 5 406 212    US-A- 5 414 370

• "METHOD TO DETERMINE SUBSTRATE POTENTIAL AND CHIP TEMPERATURE" RESEARCH DISCLOSURE, KENNETH MASON PUBLICATIONS, HAMPSHIRE, GB, Nr. 311, 1. März 1990 (1990-03-01), Seite 191 XP000104454 ISSN: 0374-4353
• BIANCHI R A ET AL: "CMOS-compatible temperature sensor with digital output for wide temperature range applications" MICROELECTRONICS JOURNAL, MACKINTOSH PUBLICATIONS LTD. LUTON, GB, Bd. 31, Nr. 9-10, Oktober 2000 (2000-10), Seiten 803-810, XP004218843 ISSN: 0026-2692

**Beschreibung**

Die vorliegende Erfindung bezieht sich auf eine Vorrichtung und ein Verfahren zur Erfassung einer Zuverlässigkeit von integrierten Halbleiterbauelementen bei hohen Temperaturen und insbesondere auf hochbeschleunigte Tests zur Ermittlung einer Zuverlässigkeit von Halbleiterschaltungen.

Eine hohe Zuverlässigkeit, insbesondere bei integrierten Halbleiterschaltungen, aber auch in der Dünnfilmtechnik stellt einen wesentlichen Faktor bei der Produktion und der späteren Verwendung dar. Es werden daher eine Vielzahl von Tests bei der Herstellung durchgeführt, um eine möglichst genaue Aussage hinsichtlich der Qualität eines jeweiligen Produkts, aber auch eines jeweiligen Herstellungsprozesses geben zu können.

Da mit fortschreitender Integrationsdichte eine Strukturbreite in Halbleiterschaltungen zunehmend verringert wird, werden entsprechende Strukturen in hochintegrierten Schaltkreisen während eines Betriebs mit sehr hohen Stromdichten und/oder Temperaturen belastet. Bei derartig hohen Stromdichten und Temperaturen können eine Vielzahl von Mechanismen zum Ausfall eines jeweiligen Halbleiterbauelements und damit der Halbleiterschaltung führen.

Derartige Mechanismen sind beispielsweise Elektromigration, wobei es zu einem Materialtransport insbesondere von Leiterbahnen in Elektronenrichtung kommt. Ferner können durch hohe stromdichten- und temperaturabhängige Beanspruchungen Dotiergebiete in einem Halbleitersubstrat auf Grund von Barrierendegradation oder eutektischer Metalldurchdringung verschlechtert oder zerstört werden. Andererseits können insbesondere in Feldeffekttransistor-Strukturen derartige Beanspruchungen auch die Eigenschaften der sogenannten Gate-und/oder Tunneloxide nachhaltig verändern, wodurch sich wiederum eine Beeinträchtigung der jeweiligen Halbleiterbauelemente ergibt. Gleiches gilt für in Halbleitersubstraten ausgebildete Kapazitäten, Induktivitäten, Speicherelemente usw., wobei beispielsweise auch Passivierungs- und Zwischendielektrika-Schichten nachhaltig durch eine derartige stromdichten-, spannungs- und/oder temperaturabhängige Beanspruchung verändert werden und bis zum Ausfall des Halbleiterbauelements führen können.

Um eine maximale Lebensdauer von Halbleiterschaltungen oder Dünnfilmschaltungen abschätzen zu können, werden daher eine Vielzahl von Zuverlässigkeitstests durchgeführt, die vorzugsweise bei erhöhten Temperaturen und Stromdichten an bestimmten Teststrukturen stattfinden. Üblicherweise wurden diese erhöhten Temperaturen in speziellen Öfen realisiert, wodurch ein beschleunigter künstlicher Alterungsprozess herbeigeführt werden kann. Da jedoch die Herstellung insbesondere von integrierten Halbleiterschaltungen mehrere Wochen dauern kann und bereits während der Herstellung bzw. unmittelbar nach Fertigstellung die Überprüfung von eventuell fehlerhaften Strukturen gewünscht ist, wurden sogenannte beschleunigte und hochbeschleunigte Tests entwickelt, die eine Abweichung in der Herstellung in regelmäßigen Kontrollmessungen ermöglichen. Diese Messungen müssen hierbei im Sekundenbereich ablaufen, um die Herstellzeit und damit die Herstellkosten von jeweiligen Halbleiterschaltungen nicht zu erhöhen.

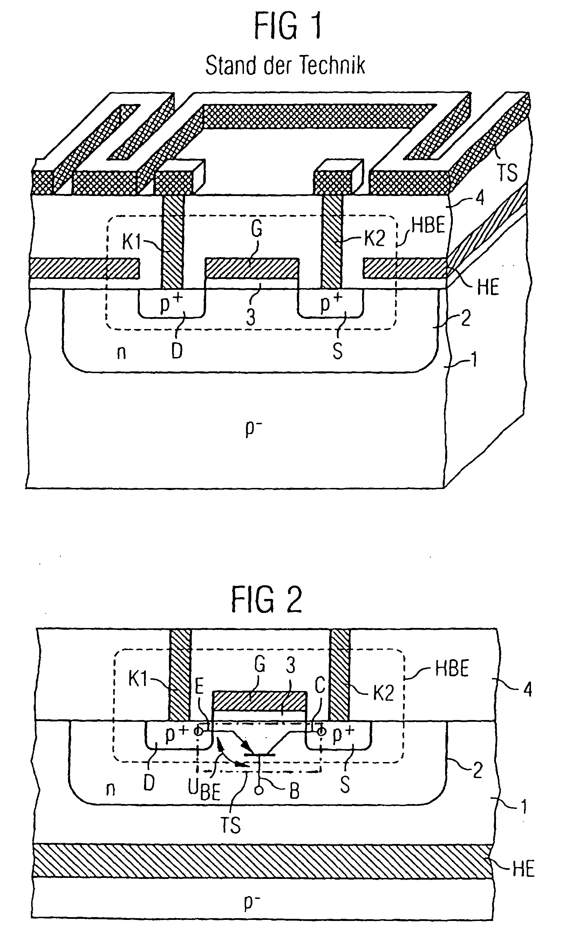

Figur 1 zeigt eine Vorrichtung zur Erfassung einer Zuverlässigkeit von integrierten Halbleiterbauelementen gemäß dem Stand der Technik, wie sie beispielsweise aus der Literaturstelle J.A. Scheideler, et al. "The Systematic Approach to Wafer Level Reliability", Solid State Technology, March 1995, Seiten 47 ff bekannt ist.

Gemäß Figur 1 befindet sich in einem Halbleitersubstrat 1, welches beispielsweise p⁻-dotiert ist, ein MOS-Transistor als zu testendes bzw. beanspruchendes integriertes Halbleiterbauelement HBE. Das Halbleiterbauelement HBE ist in einer n-Wanne 2 des Halbleitersubstrats 1 ausgebildet und besteht im Wesentlichen aus einem p⁺-dotierten Draingebiet D einen dazugehörigen Kontakt K1, einem p⁺-dotierten Sourcegebiet S mit einem dazugehörigen Kontakt K2, einer Gateoxidschicht 3 und einem Gate bzw. einer Steuerschicht G, die sich oberhalb der Gateoxidschicht 3 befindet und im Wesentlichen ein zwischen Draingebiet D und Sourcegebiet S liegendes Kanalgebiet definiert.

Zur Überprüfung der Qualität und der Prozesszuverlässigkeit werden bei einer hochintegrierten Schaltung gemäß Figur 1 Tests bei Temperaturen oberhalb der Raumtemperatur durchgeführt. Um das Degradationsverhalten zu charakterisieren, werden diverse Modelle benutzt, wobei eine genaue Kenntnis der Temperatur unerlässlich ist. Gemäß Figur 1 ist daher eine lokale Heizung bzw. ein Heizelement HE vorgesehen, die bzw. das sich in einer Isolierschicht 4 ($SiO_2$) in unmittelbarer Nähe des Halbleiterbauelements HBE befindet. Beschädigungen des Produkts auf Grund einer andernfalls notwendigen externen Heizung können dadurch vermieden werden.

Zur Erfassung der Temperatur des zu beanspruchenden Halbleiterbauelements HBE ist gemäß Figur 1 ein Temperatursensor TS in Form eines über der Isolierschicht 4 beabstandeten Aluminiummäanders vorgesehen, wobei der lineare Zusammenhang zwischen Widerstand und Temperatur der Metallleiterbahn ausgewertet wird.

Nachteilig ist jedoch bei einer derartigen Vorrichtung zur Erfassung einer Zuverlässigkeit von integrierten Halbleiterbauelementen, dass der Abstand zwischen der zu testenden Struktur bzw. dem Halbleiterbauelement HBE und dem Temperatursensor bzw. dem Aluminiummäander TS groß ist und dazwischen eine oder mehrere von isolierenden Zwischenschichten 4 liegen, die einen großen thermischen Widerstand darstellen. Dadurch ist eine ausreichend genaue und direkte Aussage bezüglich der am relevanten Gebiet der zu testenden Struktur bzw. des Halbleiterbauelements HBE anliegenden Temperatur nicht möglich. Ferner kommt es bei höheren Temperaturen auch zu einer Degradation des Aluminiums bzw. des Temperatursensors TS, weshalb eine exakte und reproduzierbare Temperaturbestimmung nach längerem Stress nicht mehr möglich ist. Als weiterer Nachteil dieser herkömmlichen Vorrichtung ist der außerordentlich hohe Platzbedarf/Kontaktflächenbedarf zu nennen, der sich im Wesentlichen aus einer 4-Punkt-Widerstandsmessung und den dafür erforderlichen Anschlussflächen (pads) ergibt.

Ferner ist aus der Literaturstelle Gerard C.M. Mejer, "Thermal Sensors Based on Transistors", Sensors and Actuators, 10 (1986) 103-125 bekannt, die Temperaturabhängigkeit eines Bipolartransistors bzw. seiner Basisemitter-Spannung zur Realisierung eines Temperatursensors zu nutzen.

Das Dokument US-A-406 212 offenbart eine Bum-In-Vorrichtung zur Erfassung der Zuverlässigkeit von integrierten Halbleiterbauelementen, die ein Trägersubstrat zum Aufnehmen eines integrierten Halbleiterbauelements, ein Heizelement zum Erwärmen des Halbleiterbauelements und einen Temperatursensor zum Erfassen einer Temperatur des Halbleiterbauelements aufweist. Alle Elemente sind unabhängig voneinander integriert und keines von ihnen ist ein parasitäres Element.

Der Erfindung liegt die Aufgabe zu Grunde eine Vorrichtung und ein Verfahren zur Erfassung einer Zuverlässigkeit von integrierten Halbleiterbauelementen zu schaffen, die eine verbesserte Genauigkeit der Temperaturbestimmung bei verringertem Platzbedarf ermöglicht.

Erfindungsgemäß wird diese Aufgabe hinsichtlich der Vorrichtung durch die Merkmale des Patentanspruchs 1 und hinsichtlich des Verfahrens durch die Maßnahmen des Patentanspruchs 10 gelöst.

Insbesondere durch die Verwendung eines Temperatursensors, der zumindest teilweise ein parasitäres Funktionselement des zu beanspruchenden Halbleiterbauelements aufweist, kann der Platzbedarf wesentlich verringert werden. Darüber hinaus wird der Temperatursensor wesentlich näher an das eigentlich relevante Gebiet des zu betrachtenden Halbleiterbauelements herangeschoben, wodurch sich die Genauigkeit der Temperaturmessung und somit die Genauigkeit des Zuverlässigkeitstests wesentlich verbessert.

Vorzugsweise besteht das parasitäre Funktionselement aus einem parasitären pn-Übergang, einem parasitären Bipolartransistor und/oder einer parasitären Schottky- oder MOS-Diode des Halbleiterbauelements. Auf diese Weise kann unter Verwendung eines üblicherweise unerwünschten und ohnehin vorhandenen parasitären Funktionselements ein jeweiliger Teilbereich des zu untersuchenden Halbleiterbauelements hochgenau und in unmittelbarer Nähe der Beanspruchung untersucht werden. Neben einer sehr exakten Temperaturbestimmung in relevanten Teilbereichen der Teststruktur bzw. des zu beanspruchenden Halbleiterbauelements ergeben sich hierbei keine Störungen der Funktionalität der Teststruktur bzw. des Halbleiterbauelements durch den Messaufnehmer und es verringert sich üblicherweise sogar die Anzahl der für die Messung benötigten Anschlüsse.

Zur Vermeidung von Beschädigungen des Produkts, wie z.B. eines Halbleiterwafers, wird das Heizelement vorzugsweise in unmittelbarer Nähe des Halbleiterbauelements im Trägersubstrat vergraben.

Zur Verbesserung einer Genauigkeit kann ein zusätzliches Funktionselement zur Vervollständigung eines parasitären Teil-Funktionselements des Temperatursensors vorgesehen werden, wobei üblicherweise Dotiergebiete und/oder Anschlussbereiche vorgesehen werden. Auf diese Weise kann mit minimalem zusätzlichem Aufwand eine weitere Erhöhung der Messgenauigkeit realisiert werden, die sich insbesondere aus der Verwendung von Bipolartransistoren als Temperatursensoren ergeben.

Bei der Beschaltung wird hierbei ein parasitäres Funktionselement aus der Vielzahl von vorhandenen parasitären Funktionselementen derart ausgewählt, dass e's sich in unmittelbarer Nähe eines zu beanspruchenden bzw. kritischen Bereichs der Teststruktur bzw. des Halbleiterbauelements befindet. Auf diese Weise können auch unterschiedliche Bereiche von komplexen Halbleiterbauelementen hinsichtlich ihrer Ausfallwahrscheinlichkeit bewertet werden.

Hinsichtlich des Verfahrens erhält man insbesondere auf Grund eines durchgeführten Messmodus, bei dem ein parasitäres Funktionselement des Halbleiterbauelements als Temperatursensor angesteuert wird, und eines durchgeführten Stressmodus, bei dem das Hälbleiterbauelement zumindest in Abhängigkeit von der Temperatur des Heizelements beansprucht wird, eine hochgenaue Aussage über die Zuverlässigkeit des Halbleiterbauelements.

Vorzugsweise wird zusätzlich eine Stress-Stromdichte am Halbleiterbauelement angelegt und berücksichtigt, wodurch sich auch stromdichteabhängige Zuverlässigkeitstests realisieren lassen.

Der Messstrom des Temperatursensors ist hierbei sehr klein, weshalb das Halbleiterbauelement im Wesentlichen unbeeinflusst bleibt.

Vorzugsweise wird der Messmodus und der Stressmodus zeitlich voneinander getrennt durchgeführt, wodurch man eine verbesserte Genauigkeit erhält. Er kann jedoch auch gleichzeitig durchgeführt werden, wobei die Messgenauigkeit nur unwesentlich verschlechtert wird, jedoch eine sogenannte real-time-Messung ermöglicht wird.

Zur Realisierung eines hochgenauen Zuverlässigkeitstests wird der Messmodus vom Stressmodus zeitlich getrennt, wobei im Messmodus eine Eichung des Heizelements erfolgt und bei der anschließenden Beanspruchung im Stressmodus der Temperatursensor bzw. die parasitären Funktionselemente nicht beschaltet sind und die Temperatur lediglich in Abhängigkeit vom geeichten Heizelement eingestellt wird. Auf diese Weise ergibt sich ein optimaler Zuverlässigkeitstest.

In den Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:

Figur 1 eine vereinfachte 3D-Schnittansicht einer herkömmlichen Zuverlässigkeits-Testvorrichtung;

Figur 2 eine vereinfachte Schnittansicht einer Zuverlässigkeits-Testvorrichtung gemäß einem ersten Ausführungsbeispiel in einem ersten Messmodus;

Figur 3 eine grafische Darstellung einer Basisemitter-Spannung des Temperatursensors gemäß Figur 2 in Abhängigkeit von einer gemessenen Temperatur;

Figur 4 eine grafische Darstellung einer vom Temperatursensor gemäß Figur 2 gemessenen Temperatur über einer tatsächlich anliegenden Temperatur;

Figur 5 eine vereinfachte Schnittansicht einer Zuverlässigkeits-Testvorrichtung gemäß dem ersten Ausführungsbeispiel in einem zweiten Messmodus;

Figur 6 eine vereinfachte Schnittansicht einer Zuverlässigkeits-Testvorrichtung gemäß dem ersten Ausführungsbeispiel in einem dritten Messmodus; und

Figur 7 eine vereinfachte Schnittansicht einer Zuverlässigkeits-Testvorrichtung gemäß einem zweiten Ausführungsbeispiel.

Figur 2 zeigt eine vereinfachte Schnittansicht einer Zuverlässigkeits-Testvorrichtung gemäß einem ersten Ausführungsbeispiel in einem ersten Messmodus, wobei gleiche Bezugszeichen gleiche oder entsprechende Elemente bezeichnen wie in Figur 1 und auf eine wiederholte Beschreibung nachfolgend verzichtet wird.

Gemäß Figur 2 befindet sich in einem p⁻-dotierten Halbleitersubstrat 1, welches vorzugsweise Silizium aufweist, eine eingebettete Heizelementschicht HE, die beispielsweise einen Polysilizium-Widerstand und das eigentliche Heizelement darstellt. Bei einer derartigen lokal in unmittelbarer Nähe eines zu testenden bzw. zu beanspruchenden Halbleiterbauelements HBE angeordneten Heizung HE können die Teststrukturen gezielt erwärmt werden, ohne dabei die auf einem Halbleiterwafer weiterhin ausgebildeten Halbleiterbauelemente auf Grund einer externen Heizung zu beschädigen.

Das zu betrachtende bzw. testende Halbleiterbauelement HBE gemäß Figur 2 stellt wiederum einen MOS-Transistor mit einem Draingebiet D, einem Sourcegebiet S und einem Gate bzw. einer Steuerschicht G dar, die über eine Isolationsschicht bzw. Gateoxidschicht 3 vom Kanalgebiet beabstandet ist. Zum Anschließen der Drain- und Sourcegebiete D und S sind elektrisch leitende Kontakte K1 und K2 vorgesehen, die mit nicht weiter dargestellten Leiter- bzw. Metallisierungsbahnen in Verbindung stehen. Der in Figur 2 dargestellte MOS-Transistor HBE befindet sich in einer im Halbleitersubstrat 1 ausgebildeten n-Wanne 2, wobei an der Substratoberfläche die Steuerschicht G von einer oder einer Vielzahl von Isolationsschichten bzw. Passivierungsschichten 4 umgeben wird. Obwohl in der Schnittansicht gemäß Figur 2 weitere Anschlusskontakte für das Substrat 1, die Steuerschicht G und die n-Wanne 2 nicht explizit dargestellt sind, sind derartige Kontakte zur definierten Potentialfestlegung der jeweiligen Gebiete üblicherweise an anderer Stelle ausgebildet.

Im Gegensatz zum Stand der Technik gemäß Figur 1 befindet sich der Temperatursensor TS nunmehr nicht in Form eines Aluminiummäanders an der Oberfläche der Isolierschicht 4, sondern ist zumindest teilweise aus parasitären Funktionselementen des Halbleiterbauelements HBE zusammengesetzt.

Genauer gesagt besitzt der MOS-Transistor bzw. das zu betrachtende Halbleiterbauelement HBE eine Vielzahl von parasitären Funktionselementen wie z. B. pn-Übergänge, parasitäre Bipolartransistoren, Schottky-Dioden, MOS-Dioden usw., die jedoch eigentlich nicht erwünscht und üblicherweise nicht beschaltet sind. Erfindungsgemäß werden nunmehr diese parasitären Funktionselemente oder Teile hiervon derart angesteuert, dass sie als Temperatursensoren verwendet werden können.

Gemäß Figur 2 kann in einem ersten Messmodus ein zwischen dem Draingebiet D und dem Sourcegebiet S sowie der n-Wanne 2 befindlicher lateraler parasitärer Bipolartransistor als Temperatursensor TS genutzt werden. Die Temperaturbestimmung kann beispielsweise mittels der Temperaturabhängigkeit des Kollektorstroms $I_C$ von einer bestimmten Basisemitter-Spannung $U_{BE}$ erfolgen. Hierbei gilt:

$$I_C = I_S * e^{(q/k*T)*U_{BE}},$$

wobei $I_S$ einen Sättigungsstrom, k die Boltzmannkonstante, q die Elementarladung und T die zu messende absolute Temperatur ist.

Da sowohl für die n-Wanne 2 als auch für die Drain- und Sourcegebiete D und S Anschlüsse üblicherweise zur Verfügung stehen, erhält man ohne zusätzlichen Mehraufwand und bei minimalem Platzbedarf einen Temperatursensor TS, der sich in unmittelbarer Nähe eines relevanten Gebiets (z.B. Kanalgebiet) des zu beanspruchenden bzw. zu testenden Halbleiterbauelements HBE befindet. Auf Grund dieser hochgenauen Temperaturbestimmung lassen sich hochgenaue und hochbeschleunigte Zuverlässigkeitstests an Halbleiterbauelementen HBE durchführen. Sowohl eine Temperaturbeanspruchung als auch eine Stromdichte-Beanspruchung sowie eine Spannungs-Beanspruchung lassen sich auf diese Weise an der Teststruktur auswerten.

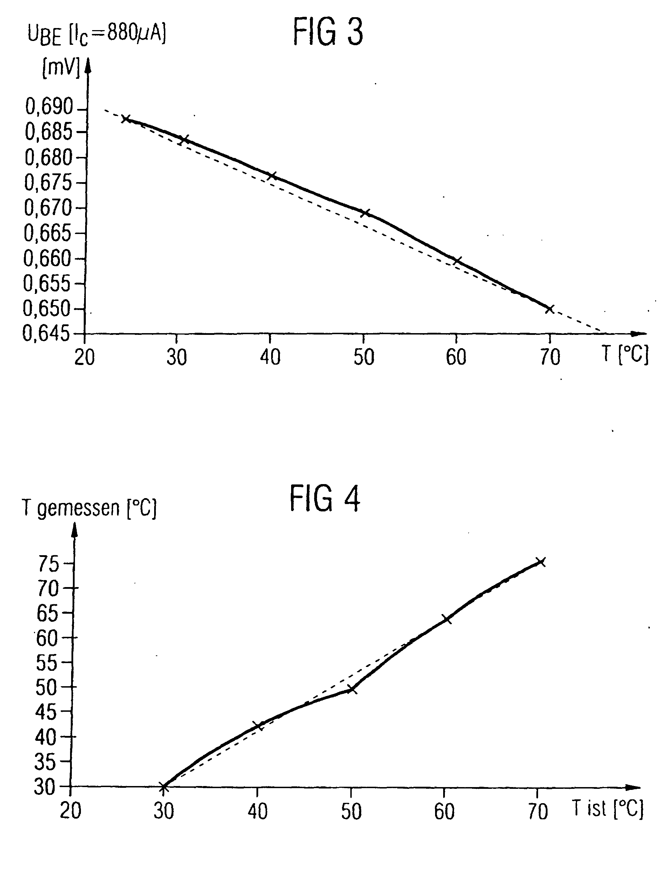

Figur 3 zeigt eine grafische Darstellung einer am Temperatursensor gemäß Figur 2 gemessenen Basisemitter-Spannung $U_{BE}$ über einer Temperatur T. Der parasitäre laterale Bipolartransistor wird hierbei in Common-Basis/Kollektor-Schaltung betrieben, wobei beispielsweise ein sehr kleiner konstanter Kollektorstrom $I_C$ = 880 Mikroampere eingeprägt wird. Bei derart geringen Messströmen kleiner einem Milliampere werden die Eigenschaften des MOS-Transistors bzw. des zu untersuchenden Halbleiterbauelements HBE kaum beeinflusst, weshalb ein Messmodus zum Durchführen einer Temperaturmessung mittels des Temperatursensors TS und ein Stressmodus zum Durchführen einer Beanspruchung des Halbleiterbauelements HBE zumindest in Abhängigkeit von der Temperatur des Heizelements HE nicht nur zeitlich getrennt, sondern auch gleichzeitig durchgeführt werden kann.

Neben der Beanspruchung durch die Temperatur des Heizelements HE kann im Stressmodus auch eine Stress-Stromdichte bzw. eine Stress-Spannung an das zu untersuchende Halbleiterbauelement HBE angelegt werden, wodurch besonders realistische Test ermöglicht werden. Bei einer gleichzeitigen Durchführung des Messmodus und des Stressmodus kann dadurch eine Testzeit zum Durchführen insbesondere bei hochbeschleunigten Zuverlässigkeitstests weiter verkürzt werden. Andererseits kann bei einem zeitlich getrennten Durchführen des Messmodus und des Stressmodus in zeitlich kurz hintereinander stattfindenden Zyklen (Chopper-Betrieb) ein hinsichtlich seiner Genauigkeit verbesserter Zuverlässigkeitstest geschaffen werden, wobei die benötigte Zeit nur unwesentlich verlängert wird. In beiden Fällen erfolgt das Auswerten des Ausfallzeitpunkts des zu untersuchenden Halbleiterbauelements in Abhängigkeit von zumindest der angelegten Temperatur oder eines Stress-Stroms bzw. -Spannung. Auf diese Weise können nicht nur fertiggestellte Halbleiterschaltungen, sondern auch sich noch in der Herstellung befindliche Halbleiterbauelemente hinsichtlich ihrer Zuverlässigkeit überprüft und auf das weitere Herstellungsverfahren ausgleichend eingegriffen werden.

Zur Realisierung einer hochgenauen Erfassung einer Zuverlässigkeit von integrierten Halbleiterbauelementen werden der Messmodus zum Messen einer durch das Heizelement HE verursachten und am Halbleiterbauelement HBE tatsächlich anliegenden Temperatur und der Stressmodus zum Durchführen einer Beanspruchung des Halbleiterbauelements HBE zeitlich voneinander getrennt, wobei im Messmodus eine Eichung des Heizelements erfolgt. Genauer gesagt wird zunächst ohne Durchführen einer Stromdichte-Beanspruchung die Temperaturkennlinie des Heizelements HE mittels des Temperatursensors TS ermittelt und anschließend die eigentliche Beanspruchung bzw. der Stressmodus bei vollständig abgeschalteten Temperatursensor durchgeführt. Die tatsächlich am Halbleiterbauelement anliegende Temperatur wird hierbei ausschließlich über das im Messmodus geeichte Heizelement HE eingestellt. Auf diese Weise kann eine Beeinflussung des Halbleiterbauelements durch einen wenn auch sehr geringen Messstrom vollständig ausgeschlossen werden, wodurch sich hochgenaue Zuverlässigkeitstests realisieren lassen.

Figur 4 zeigt eine vereinfachte grafische Darstellung zwischen einer am Temperatursensor gemäß Figur 2 gemessenen Temperatur $T_{gemessen}$ und einer über beispielsweise einen sogenannten Temperatur-Chuck bzw. eine beheizbare Haltevorrichtung tatsächlich angelegte Temperatur $T_{ist}$. Die Genauigkeit ist demzufolge außerordentlich hoch und es ergeben sich nur minimale Abweichungen von einer idealen (gestrichelten) Linie.

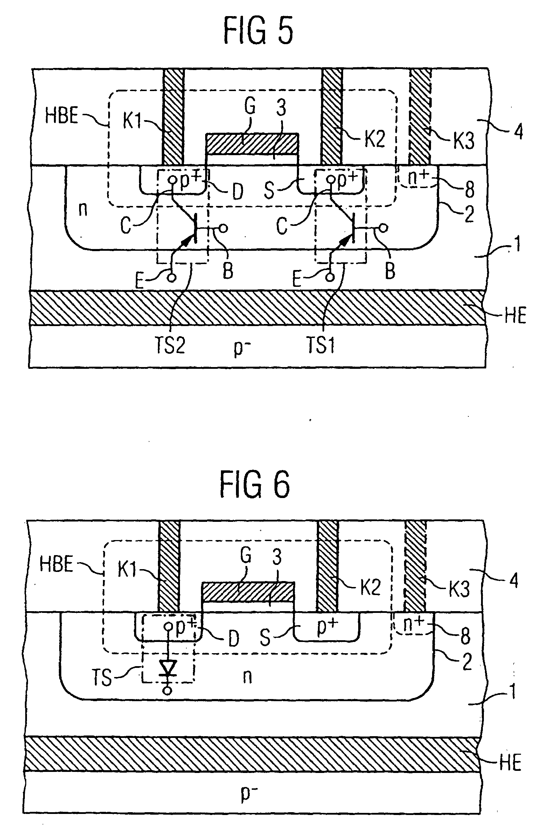

Figur 5 zeigt eine vereinfachte Schnittansicht einer Zuverlässigkeits-Testvorrichtung gemäß dem ersten Ausführungsbeispiel in einem zweiten Messmodus, wobei gleiche Bezugszeichen wiederum gleiche oder entsprechende Elemente wie in Figuren 1 und 2 bezeichnen und auf eine wiederholte Beschreibung nachfolgend verzichtet wird.

Im Gegensatz zum Messmodus gemäß Figur 2 wird beim Messmodus gemäß Figur 5 nicht der laterale parasitäre Bipolartransistor zwischen Draingebiet D und Sourcegebiet S, sondern zumindest ein vertikaler parasitärer Bipolartransistor zwischen Drain gebiet D bzw. Sourcegebiet S, der n-Wanne 2 und dem Halbleitersubstrat 1 als Temperatursensor verwendet. Ferner ist in Figur 5 ein zusätzlicher Anschlussbereich bzw. Kontakt K3 mit einem n$^+$-Diffusionsgebiet 8 dargestellt, die optional hinzugefügt werden können, falls ein derartiger Anschluss nicht unmittelbar zur Verfügung steht, anderweitig genutzt wird oder ungünstig plaziert ist. Wiederum kann beispielsweise der oder die parasitären vertikalen Bipolartransistoren TS1 und TS2 in beispielsweise Common-Basis/Kollektor-Schaltung mit einem eingeprägten Kollektorstrom $I_C$ betrieben werden und die vorherrschende Temperatur aus der Basisemitter-Spannung $U_{BE}$ abgeleitet werden. Bei Betrachtung von beiden vertikalen Transistoren TS1 und TS2 kann beispielsweise durch Differenzbildung der vorstehend beschriebenen Gleichung folgende einfache Beziehung angegeben werden:

$$U_{BE}(TS2)-U_{BE}(TS1)=K*(T2-T1),$$

wobei K eine Proportionalitätskonstante darstellt und T1 sowie T2 die jeweiligen Temperaturen an den jeweiligen vertikalen Transistoren TS1 und TS2 darstellen.

Insbesondere bei komplexen Teststrukturen bzw. zu betrachtenden Halbleiterbauelementen HBE können somit auch Teilbereiche des Halbleiterbauelements hochgenau hinsichtlich ihrer Temperatur gemessen und ausgewertet werden.

Figur 6 zeigt eine vereinfachte Schnittansicht der Zuverlässigkeits-Testvorrichtung gemäß dem ersten Ausführungsbeispiel in einem dritten Messmodus, wobei gleiche Bezugszeichen wiederum gleiche oder entsprechende Elemente wie in den Figuren 1, 2 und 5 darstellen und auf eine wiederholte Beschreibung nachfolgend verzichtet wird.

Gemäß Figur 6 werden an Stelle von parasitären Bipolartransistoren beispielsweise pn-Übergänge in Form von Dioden als Temperatursensoren TS verwendet. In Figur 6 dient hierbei eine zwischen dem Draingebiet D und der n-Wanne 2 befindliche parasitäre Diode TS der Temperaturbestimmung, wobei die Temperaturabhängigkeit des Diodenstroms $I_D$ bei einer angelegten Spannung $U_{pn}$ ausgewertet wird:

$$I_D = I_S(\exp^{(q/k*T)_*Upn} -1)$$

für $((q/k*T)*Upn) > 10$ gilt

$$I_D = I_S * \exp^{(q/k*T)*Upn},$$

wobei $I_S$ der Sättigungsstrom der Diode, T die absolute Temperatur, k die Boltzmannkonstante und $I_D$ den Diodenstrom darstellt.

Ein mittels eines pn-Übergangs dargestellter Temperatursensor TS ist im Vergleich zum vorstehend beschriebenen parasitären Bipolartransistor nicht so genau, liegt jedoch üblicherweise für jedes Halbleiterbauelement HBE als parasitäres Funktionselement vor. Wiederum kann beispielsweise mittels eines zusätzlichen Anschlussbereichs K3 der Temperatursensor TS vervollständigt oder optimiert werden.

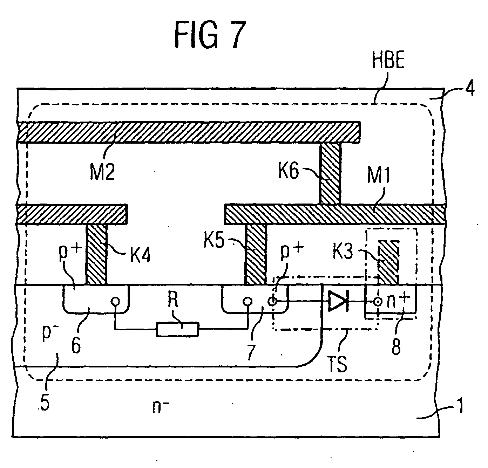

Figur 7 zeigt eine vereinfachte Schnittansicht einer Zuverlässigkeits-Testvorrichtung gemäß einem zweiten Ausführungsbeispiel wobei gleiche Bezugszeichen wiederum gleiche oder entsprechende Elemente wie in Figuren 1, 2, 5 und 6 darstellen und auf eine wiederholte Beschreibung nachfolgend verzichtet wird.

Im Gegensatz zu dem ersten Ausführungsbeispiel gemäß Figuren 2 bis 6 besteht das zu untersuchende Halbleiterbauelement HBE bzw. die Teststruktur nunmehr lediglich aus einem Widerstand R, der in einem Halbleitersubstrat 1 mittels eines p⁻-dotierten Gebiets 5 und hochdotierten p⁺-Gebieten 6 und 7 an eine Metallisierung M1 und M2 angeschaltet ist. Die Metallisierungen bzw. Metallisierungsebenen M1 und M2 sind hierbei über Kontakte bzw. "Vias" K4, K5 und K6 untereinander bzw. mit dem integrierten Widerstand R verbunden. Bei einer derartigen zu testenden Struktur sind weniger Ausfallmechanismen in einem Kanalgebiet, sondern Ausfallmechanismen an den Anschlussbereichen sowie in den Vias und Metallisierungsebenen auf Grund beispielsweise von Elektromigration von Bedeutung.

Gemäß Figur 7 kann beispielsweise über einen zusätzlichen Kontakt bzw. Via K3 und einem dazugehörigen Diffusionsgebiet 8, welches beispielsweise n⁺-dotiert ist, eine parasitäre Diode als Temperatursensor TS ausgebildet und in gleicher Weise, wie vorstehend beschrieben wurde, zur Temperaturbestimmung des integrierten Widerstands herangezogen werden. Grundsätzlich kann das zusätzliche Diffusionsgebiet 8 und der zusätzliche Anschluss K3 auch weggelassen werden, wobei ein üblicherweise vorhandener jedoch nicht dargestellter Substratanschluss für das Halbleitersubstrat 1 verwendet wird.

In gleicher Weise kann zur Erhöhung einer Genauigkeit des Zuverlässigkeitstests auch ein (nicht dargestelltes) weiteres Diffusionsgebiet mit einem Anschlussbereich hinzugefügt werden, wodurch beispielsweise eine parasitäre Bipolartransistorstruktur als Temperatursensor entsteht.

Wiederum ergibt sich eine wesentliche Verbesserung der Zuverlässigkeits-Testvorrichtung auf Grund der verbesserten Temperaturgenauigkeit und auf Grund des verringerten Platzbedarfs. Eine tatsächlich am relevanten Gebiet der zu beanspruchenden bzw. zu testenden Struktur bzw. dem Halbleiterbauelement HBE anliegenden Temperatur kann somit auf besonders einfache und platzsparende Weise ermittelt werden.

Die Erfindung wurde vorstehend anhand eines MOS-Transistors und eines integrierten Widerstands beschrieben. Sie ist jedoch nicht darauf beschränkt und umfasst in gleicher Weise integrierte Kapazitäten mit Zwischendielektrika, integrierte Induktivitäten, integrierte Dioden, integrierte Feldeffekttransistoren (inklusive Speichertransistoren), integrierte Bipolartransistoren und/oder integrierte Thyristoren. Ferner ist das Heizelement HE gemäß der vorstehenden Beschreibung in unmittelbarer Nähe des zu untersuchenden Halbleiterbauelements HBE im Trägersubstrat 1 vergraben. Es kann sich jedoch auch an anderer Stelle in einer integrierten Schaltung befinden oder als externe Heizung (Temperatur-Chuck) ausgebildet sein.

Ferner wurden vorstehend im Wesentlichen die I/U-Kennlinien von Dioden oder Transistoren als Temperaturkennlinien betrachtet. In gleicher Weise können jedoch auch C/U-Kennlinien oder sonstige temperaturabhängige Kennlinien zur Temperaturermittlung herangezogen werden. Insbesondere Schottky-Dioden oder MOS-Dioden sind zur Ermittlung von Temperaturen in Kontaktbereichen oder von Gateoxidbereichen vorteilhaft. In gleicher Weise sind neben Silizium auch alternative Halbleitermaterialien und/oder sonstige Materialien als Trägersubstrat denkbar.

Die Erfindung wurde vorstehend anhand eines MOS-Halbleiterbauelements und eines integrierten Widerstands beschrieben. Sie ist jedoch nicht darauf beschränkt und umfasst in gleicher Weise integrierte Kapazitäten, Induktivitäten, Dioden, Feldeffekttransistoren, Bipolartransistoren und/oder Thyristoren.

Bezugszeichenliste

| | |
|---|---|
| 1 | Trägersubstrat |
| 2 | n-Wanne |
| 3 | Gate-Oxidschicht |
| 4 | Isolationsschicht |
| 5 | P-Wanne |
| 6, 7, 8 | Anschlussgebiete |
| HE | Heizelement |
| TS, TS1, TS2 | Temperatursensor |
| HBE | Halbleiterbauelement |
| D | Draingebiet |
| S | Sourcegebiet |
| G | Steuerschicht |
| K1 bis K6 | Kontakte |
| B | Basis |
| E | Emitter |
| C | Kollektor |
| $U_{BE}$ | Basisemitter-Spannung |
| M1, M2 | Metallisierung |

**Patentansprüche**

1. Vorrichtung zur Erfassung der Zuverlässigkeit von integrierten Halbleiterbauelementen mit
einem Trägersubstrat (1) zum Aufnehmen des integrierten Halbleiterbauelements (HBE);
einem Heizelement (HE) zum Erwärmen des Halbleiterbauelements (HBE); und
einem Temperatursensor (TS) zum Erfassen einer Temperatur des Halbleiterbauelements (HBE),
**dadurch gekennzeichnet, dass**
der Temperatursensor (TS) ein parasitäres Funktionselement des Halbleiterbauelements (HBE) und ein zusätzliches Funktionselement (K3, 8) als Anschlussbereich des parasitären Funktionselements umfaßt.

2. Vorrichtung nach Patentanspruch 1,
**dadurch gekennzeichnet, dass** das parasitäre Funktionselement einen parasitären pn-Übergang des Halbleiterbauelements (HBE) darstellt.

3. Vorrichtung nach Patentanspruch 1,
**dadurch gekennzeichnet, dass** das parasitäre Funktionselement einen parasitären Bipolartransistor des Halbleiterbauelements (HBE) darstellt.

4. Vorrichtung nach Patentanspruch 1,
**dadurch gekennzeichnet, dass** das parasitäre Funktionselement eine parasitäre Schottky- oder MOS-Diode des Halbleiterbauelements (HBE) darstellt.

5. Vorrichtung nach einem der Patentansprüche 1 bis 4,
**dadurch gekennzeichnet, dass** das Halbleiterbauelement (HBE) einen Widerstand, eine Kapazität, eine Induktivität, eine Diode, einen Feldeffekttransistor, einen Bipolartransistor und/oder einen Thyristor aufweist.

6. Vorrichtung nach einem der Patentansprüche 1 bis 5,
**dadurch gekennzeichnet, dass** das Heizelement (HE) in unmittelbarer Nähe des Halbleiterbauelements (HBE) im Trägersubstrat (1) vergraben ist.

7. Vorrichtung nach einem der Patentansprüche 1 bis 6,
**dadurch gekennzeichnet, dass** das zusätzliche Funktionselement zumindest ein Dotiergebiet (8) und/oder einen Anschlusskontakt (K3) aufweist.

8. Vorrichtung nach einem der Patentansprüche 1 bis 7,
**dadurch gekennzeichnet, dass** das parasitäre Funktionselement in unmittelbarer Nähe eines Kritischen Bereichs des Halbleiterbauelements (HBE) liegt.

9. Verfahren zur Erfassung der Zuverlässigkeit von integrierten Halbleiterbauelementen mit den Schritten:

    a) Durchführen eines Messmodus zum Messen einer durch ein Heizelement (HE) verursachten und am Halbleiterbauelement (HBE) tatsächlich anliegenden Temperatur mittels eines Temperatursensors (TS), der ein parasitäres Funktionselement des Halbleiterbauelements (HBE) und ein zusätzliches Funktionselement (K3, 8) als Anschlussbereich des parasitären Funktionselements umfaßt;
    b) zeitlich getrenntes oder mit Schritt a) gleichzeitiges Durchführen eines Stressmodus zum Beanspruchen des Halbleiterbauelements (HBE) in Abhängigkeit von der Temperatur des Heizelements (HE); und
    c) Auswerten des Ausfallzeitpunktes des Halbleiterbauelements in Abhängigkeit von der durchgeführten Temperaturbeanspruchung.

10. Verfahren nach Patentanspruch 9,
**dadurch gekennzeichnet, dass** ferner eine Stressstromdichte und/oder eine Stressspannung im Halbleiterbauelement (HBE) bei der Beanspruchung verändert und bei der Auswertung berücksichtigt wird.

11. Verfahren nach Patentanspruch 9 oder 10,
**dadurch gekennzeichnet, dass** in Schritt a) ein Messstrom < 1mA dem Temperatursensor (TS) eingeprägt wird.

12. Verfahren nach einem der Patentansprüche 9 bis 11,
**dadurch gekennzeichnet, dass** in Schritt a) eine tatsächlich am Halbleiterbauelement (HBE) anliegende Temperatur aus einer I/U-Kennlinie oder einer C/U-Kennlinie des parasitären Funktionselements abgeleitet wird.

13. Verfahren nach einem der Patentansprüche 9 bis 12,
**dadurch gekennzeichnet, dass** Schritt a) und Schritt b) zeitlich getrennt voneinander durchgeführt werden.

14. Verfahren nach Patentanspruch 13,
**dadurch gekennzeichnet, dass** in Schritt a) eine Eichung des Heizelements (HE); und in Schritt b) eine Beanspruchung des Halbleiterbauelements (HBE) in Abhängigkeit vom geeichten Heizelement erfolgt.

15. Verfahren nach einem der Patentansprüche 9 bis 12,
**dadurch gekennzeichnet, dass** Schritt a) und Schritt b) gleichzeitig durchgeführt werden.

**Claims**

1. Device for detecting the reliability of integrated semiconductor components having
a carrier substrate (1) for receiving the integrated semiconductor component (HBE);
a heating element (HE) for heating the semiconductor component (HBE); and
a temperature sensor (TS) for detecting a temperature of the semiconductor component (HBE),
**characterized in that** the temperature sensor (TS) comprises a parasitic functional element of the semiconductor component (HBE) and an additional functional element (K3, 8) as connection region of the parasitic functional element.

2. Device according to Patent Claim 1,
**characterized in that** the parasitic functional element constitutes a parasitic pn junction of the semiconductor component (HBE).

3. Device according to Patent Claim 1,

**characterized in that** the parasitic functional element constitutes a parasitic bipolar transistor of the semiconductor component (HBE).

4. Device according to Patent Claim 1,
**characterized in that** the parasitic functional element constitutes a parasitic Schottky or MOS diode of the semiconductor component (HBE).

5. Device according to one of Patent Claims 1 to 4,
**characterized in that** the semiconductor component (HBE) has a resistor, a capacitance, an inductance, a diode, a field-effect transistor, a bipolar transistor and/or a thyristor.

6. Device according to one of Patent Claims 1 to 5,
**characterized in that** the heating element (HE) is buried in direct proximity to the semiconductor component (HBE) in the carrier substrate (1).

7. Device according to one of Patent Claims 1 to 6,
**characterized in that** the additional functional element has at least one doping region (8) and/or a connection contact (K3).

8. Device according to one of Patent Claims 1 to 7,
**characterized in that** the parasitic functional element lies in direct proximity to a critical region of the semiconductor component (HBE).

9. Method for detecting the reliability of integrated semiconductor components having the steps of:

a) carrying out a measurement mode for measuring a temperature that is caused by a heating element (HE) and is actually present at the semiconductor component (HBE), by means of a temperature sensor (TS) which comprises a parasitic functional element of the semiconductor component (HBE) and an additional functional element (K3, 8) as connection region of the parasitic functional element;
b) carrying out, temporally separately or simultaneously with step a), a stress mode for stressing the semiconductor component (HBE) in a manner dependent on the temperature of the heating element (HE); and
c) evaluating the failure instant of the semiconductor component in a manner dependent on the temperature stressing carried out.

10. Method according to Patent Claim 9,
**characterized in that** furthermore a stress current density and/or a stress voltage in the semiconductor component (HBE) is altered during the stressing and is taken into account during the evaluation.

11. Method according to Patent Claim 9 or 10,

**characterized in that**, in step a), a measurement current < 1mA is impressed on the temperature sensor (TS).

12. Method according to one of Patent Claims 9 to 11, **characterized in that**, in step a), a temperature actually present at the semiconductor component (HBE) is derived from an I/U characteristic curve or a C/U characteristic curve of the parasitic functional element.

13. Method according to one of Patent Claims 9 to 12, **characterized in that** step a) and step b) are carried out separately from one another with respect to time.

14. Method according to Patent Claim 13, **characterized in that** the heating element (HE) is calibrated in step a); and the semiconductor component (HBE) is stressed in a manner dependent on the calibrated heating element in step b).

15. Method according to one of Patent Claims 9 to 12, **characterized in that** step a) and step b) are carried out at the same time.


**Revendications**

1. Dispositif de détermination de la fiabilité de composants à semi-conducteurs intégrés comprenant
   un substrat (1) support de réception du composant (HBE) à semi-conducteur intégré ;
   un élément (HE) chauffant de chauffage du composant (HBE) à semi-conducteur ; et
   un capteur (TS) de température pour relever une température du composant (HBE) à semi-conducteur,
   **caractérisé en ce que**
   le capteur (TS) de température comprend un élément fonctionnel parasite du composant (HBE) à semi-conducteur et un élément (K3, 8) fonctionnel supplémentaire comme zone de borne de l'élément fonctionnel parasite.

2. Dispositif suivant la revendication 1, **caractérisé en ce que** l'élément fonctionnel parasite représente une jonction pn parasite du composant (HBE) à semi-conducteur.

3. Dispositif suivant la revendication 1, **caractérisé en ce que** l'élément fonctionnel parasite représente un transistor bipolaire parasite du composant (HBE) à semi-conducteur.

4. Dispositif suivant la revendication 1, **caractérisé en ce que** l'élément fonctionnel parasite représente une diode de Schottky ou une diode MOS parasite du composant (HBE) à semi-conducteur.

5. Dispositif suivant l'une des revendications 1 à 4, **caractérisé en ce que** le composant (HBE) à semi-conducteur comporte une résistance, une capacité, une inductance, une diode, un transistor à effet de champ, un transistor bipolaire et/ou un thyristor.

6. Dispositif suivant l'une des revendications 1 à 5, **caractérisé en ce que** l'élément (HE) chauffant est enterré à proximité immédiate du composant (HBE) à semi-conducteur dans le substrat (1) support.

7. Dispositif suivant l'une des revendications 1 à 6, **caractérisé en ce que** l'élément fonctionnel supplémentaire comporte au moins une zone (8) de dopage et/ou un contact (K3) de borne.

8. Dispositif suivant l'une des revendications 1 à 7, **caractérisé en ce que** l'élément fonctionnel parasite se trouve à proximité immédiate d'une zone critique du composant (HBE) à semi-conducteur.

9. Procédé de détermination de la fiabilité de composants à semi-conducteurs intégrés, dans lequel :

   a) on effectue un mode de mesure pour mesurer une température provoquée par un élément (HE) chauffant et s'appliquant en fait au composant (HBE) à semi-conducteur au moyen d'un capteur (TS) de température qui comprend un élément fonctionnel parasite du composant (HBE) à semi-conducteur et un élément (K3, 8) fonctionnel supplémentaire en tant que zone de borne de l'élément fonctionnel parasite ;
   b) à distance dans le temps ou en même temps que le stade a), on effectue un mode de stress pour solliciter le composant (HBE) à semi-conducteur en fonction de la température de l'élément (HE) chauffant ; et
   c) on exploite le point de défaillance du composant à semi-conducteur en fonction de la sollicitation en température qui a été effectuée.

10. Procédé suivant la revendication 9, **caractérisé en ce qu'**on modifie, en outre, une densité de courant de stress et/ou une tension de stress dans le composant (HBE) à semi-conducteur lors de la sollicitation et on en tient compte lors de l'exploitation.

11. Procédé suivant la revendication 9 ou 10, **caractérisé en ce que** l'on imprime au stade a) un courant de mesure inférieur à 1 mA au capteur (TS) de température.

**12.** Procédé suivant l'une des revendications 9 à 11, **caractérisé en ce qu'**au stade a), on déduit une température s'appliquant réellement au composant (HBE) à semi-conducteur d'une courbe caractéristique I/U ou d'une courbe caractéristique C/U de l'élément fonctionnel parasite.

**13.** Procédé suivant l'une des revendications 9 à 12, **caractérisé en ce que** l'on effectue le stade a) et le stade b) séparément l'un de l'autre dans le temps.

**14.** Procédé suivant la revendication 13, **caractérisé en ce que** l'on effectue au stade a) un étalonnage de l'élément (HE) chauffant ; et au stade b) une sollicitation du composant (HBE) à semi-conducteur en fonction de l'élément chauffant étalonné.

**15.** Procédé suivant l'une des revendications 9 à 12, **caractérisé en ce que** l'on effectue le stade a) et le stade b) en même temps.

# FIG 1
## Stand der Technik

# FIG 2

## FIG 3

$U_{BE}$ [$I_C$=880µA]

[mV]

0,690
0,685
0,680
0,675
0,670
0,665
0,660
0,655
0,650
0,645

20    30    40    50    60    70    T [°C]

## FIG 4

T gemessen [°C]

75
70
65
60
55
50
45
40
35
30

20    30    40    50    60    70    T ist [°C]

EP 1 279 966 B1

## FIG 5

## FIG 6

# FIG 7